Europäisches Patentamt

European Patent Office

Office européen des brevets

(19)

(11) **EP 1 099 117 B1**

(12) **EUROPÄISCHE PATENTSCHRIFT**

(45) Veröffentlichungstag und Bekanntmachung des Hinweises auf die Patenterteilung:
**29.05.2002 Patentblatt 2002/22**

(21) Anmeldenummer: **99963128.6**

(22) Anmeldetag: **12.07.1999**

(51) Int Cl.⁷: **G01R 15/24**

(86) Internationale Anmeldenummer:
**PCT/DE99/02147**

(87) Internationale Veröffentlichungsnummer:
**WO 00/05590 (03.02.2000 Gazette 2000/05)**

(54) **VERFAHREN UND EINRICHTUNG ZUR MESSUNG EINER ELEKTRISCHEN SPANNUNG MIT HILFE DES POCKELSEFFEKTES**

METHOD AND DEVICE FOR MEASURING AN ELECTRIC VOLTAGE USING THE POCKELS EFFECT

PROCEDE ET DISPOSITIF POUR MESURER UNE TENSION ELECTRIQUE A L'AIDE DE L'EFFET DE POCKEL

(84) Benannte Vertragsstaaten:
**DE FR GB**

(30) Priorität: **23.07.1998 DE 19833233**

(43) Veröffentlichungstag der Anmeldung:
**16.05.2001 Patentblatt 2001/20**

(73) Patentinhaber: **SIEMENS AKTIENGESELLSCHAFT 80333 München (DE)**

(72) Erfinder: **KRÄMMER, Peter D-91052 Erlangen (DE)**

(56) Entgegenhaltungen:
**EP-A- 0 293 842          EP-A- 0 361 832
US-A- 5 059 894          US-A- 5 157 324**

• **PATENT ABSTRACTS OF JAPAN vol. 007, no. 202 (P-221), 7. September 1983 (1983-09-07) & JP 58 099761 A (SUMITOMO DENKI KOGYO KK), 14. Juni 1983 (1983-06-14)**

**Beschreibung**

Die Erfindung bezieht sich auf ein Verfahren und eine Vorrichtung zur Messung einer elektrischen Spannung mit Hilfe des Pockelseffektes.

Beim Pockelseffekt handelt es sich um einen elektrooptischen Effekt, bei dem in einem Kristall (Pockelskristall) eine lineare Doppelbrechung induziert wird, die proportional zu einem am Kristall angelegten elektrischen Feld ist. Durch die vom elektrischen Feld induzierte lineare Doppelbrechung wird zwischen zwei senkrecht zueinander polarisierten Komponenten eines sich im Pockelskristall fortpflanzenden Lichtstrahls eine Phasenverschiebung induziert, die proportional zu dem Produkt aus der Länge 1 des Pockelskristalls und der elektrischen Feldstärke E ist. Je nachdem, ob das elektrische Feld E senkrecht oder parallel zur Ausbreitungsrichtung des Lichtstrahls orientiert ist, spricht man vom transversalen bzw. longitudinalen Pockelseffekt.

Die vom Pockelskristall erzeugte Phasenverschiebung zwischen den beiden senkrecht zueinander linear polarisierten Komponenten wird mit Hilfe einer Analysatoreinrichtung gemessen. Diese Phasenverschiebung ist proportional zum Wegintegral über die Feldstärke und damit beim longitudinalen Pockelseffekt proportional zur elektrischen Spannung zwischen der Lichteintrittsfläche und der Lichtaustrittsfläche des Pockelskristalls und beim transversalen Pockelseffekt proportional zur elektrischen Spannung und proportional zur Länge des Wegs zwischen Lichteintrittsfläche und Lichtaustrittsfläche. Da zu jeder Phasenverschiebung, die größer als $\lambda/2$ ist, zumindest eine Phasenverschiebung existiert, die kleiner als $\lambda/2$ ist und dasselbe Meßergebnis in der Analysatoreinrichtung erzeugt, können ohne weitere Maßnahmen nur elektrische Spannungen eindeutig gemessen werden, die kleiner sind als die zur Phasenverschiebung $\lambda/2$ gehörende sogenannte Halbwellenspannung $V_H$. Diese Halbwellenspannung $V_H$ beträgt beispielsweise für den longitudinalen Pockelseffekt für KDP bei einer Wellenlänge von 546 nm etwa 7,6 kV.

Das in den Pockelskristall eingekoppelte Licht ist in der Regel unter 45° zu den senkrecht zur Strahlachse orientierten Polarisationseigenachsen des Pockelskristalls linear polarisiert. Für die Intensität des hinter einem in gleicher Weise angeordneten Analysator gemessenen Lichtes gilt nun die Beziehung

$$I = I_0 \cos^2 \varphi/2$$

wobei $\varphi$ die Phasenverschiebung in Bogenmaß ($\lambda/2$ entspricht $\varphi = 180°$) und $I_0$ die hinter dem Analysator gemessene Intensität bei Abwesenheit eines elektrischen Feldes ist.

Wird nun mit Hilfe des longitudinalen Pockelseffektes eine Wechselspannung gemessen, so kann durch Abzählen der Nulldurchgänge auch eine Wechselspannungsamplitude gemessen werden, die ein Vielfaches der Halbwellenspannung $V_H$ beträgt.

Zur Erhöhung der Genauigkeit der Spannungsmessung und zur eindeutigen Bestimmung der maximalen Amplitude eines Wechselspannungssignals ist es aus der *EP 0 361 832 B1* bekannt, in den Pockelskristall zwei linear polarisierte Lichtstrahlen einzukoppeln, die gegeneinander um $\lambda/4$ phasenverschoben sind. Dadurch werden zwei zueinander um 45° versetzte Intensitätssignale erzeugt. Ist eines der beiden Intensitätssignale im Bereich minimaler Steigung, d.h. minimaler Empfindlichkeit, so ist das andere Intensitätssignal gerade im Bereich maximaler Steigung oder Empfindlichkeit. Da zwei Intensitätssignale ausgewertet werden, können sowohl die maximalen Spannungsamplituden eindeutig identifiziert werden als auch eine höhere Meßgenauigkeit erzeugt werden.

Bei der Messung hoher Spannungen mit Hilfe des longitudinalen Pockelseffektes liegt jedoch zwischen der Eintrittsfläche und der Austrittsfläche des Pockelskristalls eine hohe Potentialdifferenz an. Da an beide Flächen optische Lichtleitfasern angekoppelt und zu einer Auswerteeinrichtung geführt werden müssen, überbrücken diese ein Gebiet mit hoher Spannungsdifferenz. Dies führt insbesondere unter beengten räumlichen Verhältnissen zu elektrischen Isolationsproblemen.

In der *US 5,059,894* wird nun zur Vermeidung des vorstehend genannten Nachteils eine reflexive Anordnung vorgeschlagen, bei der das Licht nach Durchquerung des Pockelskristalls in einer Reflexionsanordnung reflektiert und erneut in den Pockelskristall eingekoppelt wird, so daß es diesen ein zweites Mal durchquert. Einkoppel- und Auskoppelfläche des Pockelskristalls fallen in dieser Ausführungsform zusammen. Die an den Pockelskristall angekoppelten Lichtleiter befinden sich somit alle auf gleichem Potential, so daß die vorstehend genannten Probleme nicht mehr auftreten. Auch in diesem Falle ist es jedoch zum Herstellen einer eineindeutigen Beziehung zwischen der gemessenen Intensität und dem Wert der zu messenden Spannung erforderlich, daß die Anzahl der Nulldurchgänge bekannt ist, so daß sich die bekannten Verfahren prinzipiell nur zur Messung von reinen Wechselspannungen eignen. Wechselspannungen mit einem Gleichspannungsanteil können mit den bekannten Verfahren nur gemessen werden, wenn ein Anfangswert bekannt ist und beim Abzählen kein Nulldurchgang verloren geht.

Der Erfindung liegt nun die Aufgabe zugrunde, ein Verfahren und eine Einrichtung zur Messung einer elektrischen Spannung mit Hilfe des Pockelseffektes anzugeben, mit der Wechselspannungen mit einem Gleichspannungsanteil auch ohne Kenntnis eines Anfangswertes mit hoher Genauigkeit gemessen werden können.

Hinsichtlich des Verfahrens wird die genannte Aufgabe gelöst mit einem Verfahren mit den Merkmalen des Patentanspruches 1. Bei dem erfindungsgemäßen Verfahren zur Messung einer elektrischen Spannung unter Ausnutzung des longitudinalen und des transversalen Pockelseffekts wird in einem Pockeiskristall zumindest ein erster und ein zumindest ein zweiter linear polarisierter Lichtstrahl eingekoppelt, die sich im Pokkelskristall senkrecht zueinander ausbreiten. Die Länge des Lichtwegs des ersten Lichtstrahls im Pockelskristall ist derart bemessen, daß innerhalb eines vorbestimmten Meßbereiches eine eineindeutige Beziehung zwischen der hinter einem ersten Analysator gemessenen ersten Intensität und der Spannung besteht. Die gemessene erste Intensität wird nun dazu benutzt, um aus den der gemessenen zweiten Intensität jeweils aufgrund der Periodizität zugeordneten Mehrzahl von möglichen Spannungswerten einen Spannungswert auszuwählen. Die gemessene erste Intensität legt somit aus der periodischen Beziehung zwischen zweiter Intensität und Spannung einen Ausschnitt oder Meßbereich fest, in dem die Beziehung zwischen zweiter Intensität und Spannung eineindeutig ist.

Mit anderen Worten: Die erste Intensität wird zum Herstellen einer eineindeutigen Beziehung zwischen der Spannung und der hinter einem zweiten Analysator gemessenen und innerhalb des Meßbereiches periodisch von der Spannung abhängigen zweiten Intensität verwendet.

Auf diese Weise kann durch gleichzeitige Ausnutzung des longitudinalen und des transversalen Pockelseffektes bei geeignet dimensionierter unterschiedlicher Längsausdehnung des Pockelskristalles parallel und senkrecht zum elektrischen Feld eine relativ ungenaue eineindeutige Relation zwischen der ersten Intensität und der elektrischen Spannung dazu benutzt werden, die aufgrund der periodisch von der Spannung abhängigen zweiten Intensität vorliegende Vieldeutigkeit des Meßresultates zu eliminieren. Dabei kann auch bei reinen Gleichspannungen oder bei Wechselspannungen mit einem hohen Gleichspannungsanteil ein genaues Meßergebnis erzielt werden, da die zweite Intensität mit relativ hoher Empfindlichkeit von der Spannung abhängt.

Geeignete Pockelskristalle sind beispielsweise kubische Kristalle, die unter Einwirkung eines elektrischen Feldes optisch einachsig werden, so daß sich stets eine Kristallorientierung finden läßt, die zugleich einen transversalen und longitudinalen Pockeleffekt zeigt.

In einer besonders bevorzugten Ausgestaltung der Erfindung werden in den Pockelskristall zwei zweite Lichtstrahlen eingekoppelt, die unter 45° zu den senkrecht zur Strahlachse orientierten Polarisationseigenachsen des Pockelskristalls linear polarisiert sind, wobei die beiden ersten Lichtstrahlen auf ihrem Lichtweg außerhalb des Pockelskristalls relativ zueinander um ein ungeradzahliges Vielfaches von λ/4 phasenverschoben werden. Durch diese Maßnahme ist sichergestellt, daß für jeden Spannungswert innerhalb des gesamten Meßbereiches zumindest eine der beiden zweiten Intensitäten mit relativ hoher Empfindlichkeit von der Spannung abhängt.

Hinsichtlich der Einrichtung wird die Aufgabe gelöst, mit einer Einrichtung mit den Merkmalen des Patentanspruches 7. Die erfindungsgemäße Einrichtung enthält einen Pockelskristall und eine Lichtquellenanordnung zum Erzeugen und Einkoppeln wenigstens eines ersten und wenigstens eines zweiten linear polarisierten Lichtstrahls in den Pockelskristall derart, daß sich diese im Pockelskristall senkrecht zueinander ausbreiten. Dem Pockelskristall ist eine Analysatoreinrichtung zum Messen einer von der Spannung abhängigen ersten Intensität des ersten Lichtstrahls und eine von der Spannung abhängigen zweiten Intensität des zweiten Lichtstrahls zugeordnet, wobei die Länge des Lichtwegs des ersten Lichtstrahls im Pockelskristall derart bemessen ist, daß innerhalb eines vorbestimmten Meßbereiches eine eineindeutige Beziehung zwischen der hinter einem ersten Analysator gemessenen ersten Intensität und der Spannung besteht, und wobei die Länge des Lichtweges des zweiten Lichtstrahls im Pockelskristall derart bemessen ist, daß innerhalb des vorbestimmten Meßbereiches eine periodische Beziehung zwischen der hinter einem zweiten Analysator gemessenen zweiten Intensität und der Spannung besteht. Dem ersten und zweiten Analysator ist außerdem eine Auswerteeinrichtung zum Auswählen eines eindeutigen Meßwertes für die Spannung und der zweiten Intensität nachgeordnet.

Weitere vorteilhafte Ausgestaltungen der Erfindung ergeben sich gemäß der jeweiligen Unteransprüche.

Zur weiteren Erläuterung der Erfindung wird auf das Ausführungsbeispiel der Zeichnung verwiesen. Es zeigen:

FIG 1      eine Einrichtung zum Messen einer elektrischen Spannung in einer schematischen Darstellung.

FIG 2a,b      jeweils ein Diagramm, in dem die hinter den Analysatoren gemessene Intensität des zweiten bzw. des ersten Lichtstrahls gegen die Spannung aufgetragen ist.

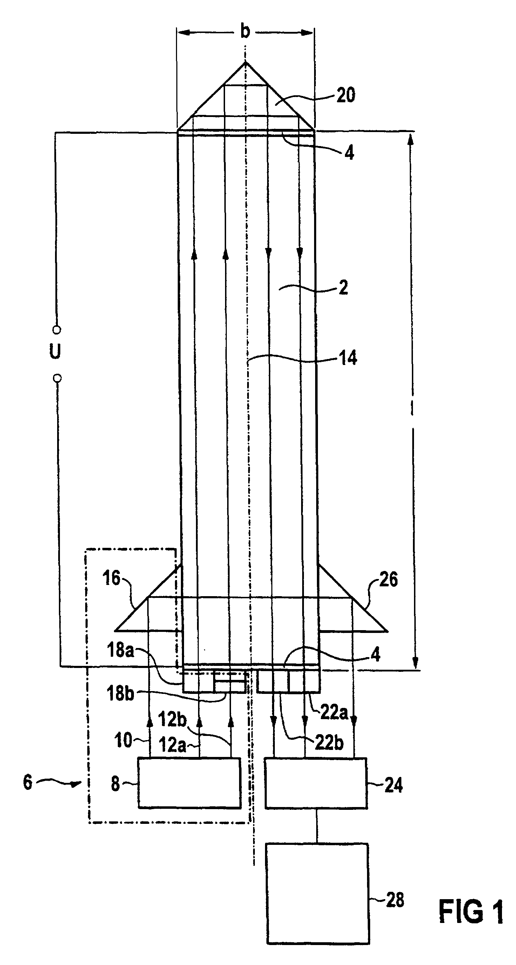

Gemäß FIG 1 ist ein quaderförmiger Pockelskristall 2 an seinen Stirnflächen 4 mit optisch transparenten Elektroden versehen, an die eine zu messende Spannung U angelegt werden kann. Die Breite b des Pockelskristalls 2 ist sehr viel kleiner als seine Länge 1.

Dem Pockelskristall 2 ist eine Lichterzeugungseinrichtung 6 zugeordnet, die eine Lichtquelle oder Lichtquellenanordnung 8 umfaßt, die einen ersten Lichtstrahl 10 und zwei zweite Lichtstrahlen 12a, 12b erzeugt. Die zweiten Lichtstrahlen 12a, 12b breiten sich parallel zueinander und parallel zur Längsachse oder Längsrichtung 14 des Pockelskristalls 2 aus.

Der erste Lichtstrahl 10 wird in einem seitlich am Pockelskristall 2 angeordneten polarisierenden Strahlteiler 16 um 90° umgelenkt und in den Pockelskristall 2 eingekoppelt, so daß er den Pockelskristall 2 senkrecht zur Längsrichtung 14, d.h. in Richtung seiner Breite b durchquert.

Die zweiten Lichtstrahlen 12a, 12b werden über Polarisatoren 18a, 18b in die Stirnfläche des Pockelskristalls 2 eingekoppelt und pflanzen sich im Pockelskristall 2 parallel zu seiner Längsrichtung 14, d.h. senkrecht zur Ausbreitungsrichtung des ersten Lichtstrahls 10 im Pockelskristall 2 aus, so daß die Länge ihres Lichtwegs im Pockelskristall 2 seiner Länge l entspricht.

Die Polarisatoren 18a, 18b erzeugen einen unter 45° zu den senkrecht zur Längsachse 14 orientierten Polarisationseigenachsen linear polarisierte Lichtstrahlen 12a und 12b. Einer der Polarisatoren 18a öder 18b enthält außerdem eine λ/4-Verzögerungsplatte, die eine relative Phasenverschiebung zwischen den in dem Pockelskristall 2 eingekoppelten zweiten Lichtstrahlen 12a und 12b um λ/4 oder 90° bewirken.

Durch eine solche, aus der eingangs erwähnten EP 0 361 832 B1 bekannte Anordnung werden zwei um 90° versetzte Kennlinien erzeugt, so daß stets im gesamten Meßbereich eine hohe Empfindlichkeit gewährleistet ist.

Die zweiten Lichtstrahlen 12a und 12b durchqueren den Pockelskristall 2 parallel zu einem von der elektrischen Spannung U erzeugten elektrischen Feld und treten an der von der Lichterzeugungseinrichtung 6 abgewandten Stirnseite aus dem Pockelskristall 2 in ein Umlenkprisma 20 aus und werden erneut in dem Pockelskristall 2 eingekoppelt, den sie dann ein zweites Mal in umgekehrter Richtung durchqueren. Nach dieser erneuten Durchquerung treten die zweiten Lichtstrahlen 12a und 12b aus dem Pockelskristall 2 aus und durchqueren jeweils einen zweiten Analysator 22a bzw. 22b und gelangen von dort in eine Empfangseinrichtung 24, in der die jeweilige Intensität $I_{2a}$ und $I_{2b}$ der von den zweiten Analysatoren 22a bzw. 22b durchgelassenen zweiten Lichtstrahlen 12a bzw. 12b gemessen wird.

Der erste Lichtstrahl 10 durchquert den Pockelskristall 2 senkrecht zu dessen Längsrichtung 14, wobei mit Hilfe des polarisierenden Strahlteilers 16 eine Linearpolarisation erzeugt wird, deren Polarisationsebene untere 45° zu den senkrecht zu dieser Strahlachse orientierten Polarisationseigenachsen orientiert ist. Ein als erster Analysator 26 wirkender polarisierender Strahlteiler lenkt den aus dem Pockelskristall 2 austretenden ersten Lichtstrahl 10 um 90° um, so daß dieser in die Empfangseinrichtung 24 gelangt, in der seine Intensität $I_1$ gemessen wird.

Die Meßwerte der Intensitäten $I_1$, $I_{2a}$ und $I_{2b}$ werden an eine Auswerteeinrichtung 28 weitergeleitet, in der zwischen der Spannung U und den hinter den zweiten Analysatoren gemessenen zweiten Intensitäten $I_{2a}$ und $I_{2b}$ mit Hilfe der ersten Intensität $I_1$ eine eineindeutige Beziehung hergestellt wird.

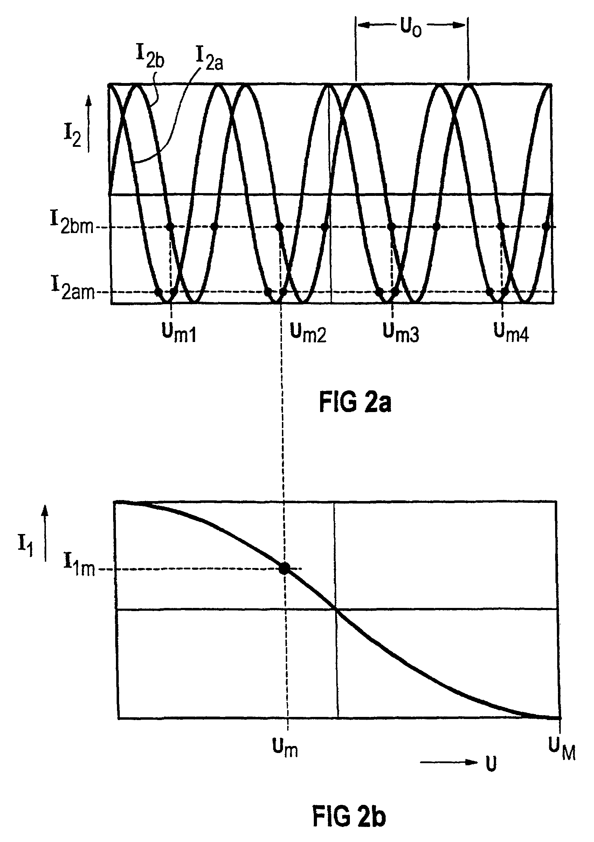

Dies wird anhand Figuren 2a und 2b näher erläutert, in denen die zweiten Intensitäten $I_{2a}$ und $I_{2b}$ bzw. die erste Intensität $I_1$ jeweils gegen die Spannung U aufgetragen sind. In diesen Figuren ist nun zu erkennen, daß die Breite b des Pockelskristalls so bemessen ist, daß sich innerhalb eines vorbestimmten Meßbereiches $U_M$ eine eineindeutige Beziehung zwischen der gemessenen ersten Intensität $I_1$ und der Spannung U ergibt. Mit anderen Worten: Jedem Meßwert $I_{1m}$ der ersten Intensität $I_1$ kann eindeutig ein Spannungswert $U_m$ zugeordnet werden und umgekehrt.

Die Länge l des Pockelskristalls ist demgegenüber so groß gewählt, daß die zweiten Intensitäten $I_{2a}$ und $I_{2b}$ periodisch von der Spannung U mit der Periode $U_0$ abhängen, wobei im Ausführungsbeispiel innerhalb des Meßbereiches $U_M$ vier Perioden auftreten. Die Beziehung zwischen der Spannung U und den zweiten Intensitäten $I_{2a}$, $I_{2b}$ ist somit nur in den Kurvenabschnitten zwischen den Minima und Maxima eineindeutig. Im Ausführungsbeispiel führt somit der Spannungswert $U_m$ zu Meßwerten $I_{2am}$ und $I_{2bm}$ der zweiten Intensitäten $I_{2a}$ und $I_{2b}$.

Der Figur kann nun entnommen werden, daß diesen Meßwerten aufgrund der vier Perioden vier Spannungswerte $U_{m1-4}$ zugeordnet werden können. Mit Hilfe des Meßwerts $I_{1m}$ für die Intensität $I_1$ des ersten Lichtstrahls kann nun die Entscheidung getroffen werden, welche der Spannungswerte $U_{m1}$, $U_{m2}$, $U_{m3}$, $U_{m4}$ dem genauen Wert entspricht. Dies ist im Beispiel der Spannungswert $U_{m2}$, wobei im Beispielfall der anhand der Kennlinie $I_{2b}$ gewonnene Meßwert aufgrund der in diesem Fall in der Umgebung dieses Meßwerts vorliegenden höheren Empfindlichkeit herangezogen wird. Mit Hilfe des Meßwertes $I_{1m}$ kann somit aus dem periodischen Kurvenverlauf der Kennlinien $U/I_{2a,2b}$ ein Bereich oder Kurvenabschnitt ausgewählt werden, in dem eine eineindeutige Beziehung zwischen der Spannung U und der zweiten Intensität $I_{2a}$, $I_{2b}$ besteht.

Die Auswahl des korrekten Spannungswerts $U_{m2}$ kann beispielsweise dadurch geschehen, daß für alle Spannungswerte $U_{m1}$ die Differenz $U_m - U_{m1}$ gebildet und diese Differenz mit der Periode $U_0$ verglichen wird. Der korrekte Spannungswert ist nun derjenige Spannungswert $U_{m1}$, für den diese Differenz minimal wird.

Zur Auswahl des korrekten Meßwertes sind auch andere Algorithmen möglich, mit denen beispielsweise eine ganze Zahl n aus der Beziehung $n = int(U_m/U_0)$ errechnet wird, wobei int eine Funktion ist, die eine reelle Zahl auf ihren ganzzahligen Anteil zurückführt. In diesem Fall kann die korrekte Spannung U einfach dadurch bestimmt werden, daß zu dem in die erste Periode fallenden Meßwert $U_{m1}$ das Produkt aus (n-1) und $U_0$ addiert wird.

**Patentansprüche**

**1.** Verfahren zur Messung einer elektrischen Spannung (U) unter Ausnutzung des longitudinalen und des transversalen Pockelseffektes, bei dem in einen Pockelskristall (2) zumindest ein erster und zumindest ein zweiter linearpolarisierter Lichtstrahl (10 bzw. 12a,b) eingekoppelt werden, die sich im Pockelskristall (2) senkrecht zueinander ausbreiten, wobei die Länge des Lichtwegs des ersten Lichtstrahls (10) im Pockelskristall (2) derart bemessen ist, daß innerhalb eines vorbestimmten Meßbereiches ($U_M$) eine eineindeutige Beziehung zwischen der hinter einem ersten Analysator (26) gemessenen ersten Intensität ($I_1$) und der Spannung (U) besteht und diese zum Auswählen eines eindeutigen Meßwertes für die Spannung (U) aus der hinter einem zweiten Analysator (22a,b) gemessenen und innerhalb des Meßbereiches ($U_M$) periodisch von der Spannung (U) abhängigen zweiten Intensität ($I_{2a},I_{2b}$) verwendet wird.

2. Verfahren nach Anspruch 1, bei dem aus der ersten Intensität ($I_1$) eine ganze Zahl n abgeleitet wird, die angibt, zu welcher Periode die zweite Intensität ($I_{2a}$, $I_{2b}$) gehört.

3. Verfahren nach Anspruch 2, bei dem aus einem aus der ersten Intensität ($I_1$) ermittelten ersten Meßwert ($U_m$) der Spannung (U) die ganze Zahl n aus der Beziehung $n = int((U_m/U_0)$ errechnet wird, wobei $U_0$ die Periode der zweiten Intensität ($I_{2a},I_{2b}$) ist, und bei dem der zweiten Intensität ($I_{2a},I_{2b}$) ein zur ersten Periode gehörender zweiter Meßwert $U_{m1} < U_0$ zugeordnet wird und die Spannung (U) durch die Beziehung $U_{m1}+(n-1)U_0$ ermittelt wird.

4. Verfahren nach Anspruch 1, 2 oder 3, bei dem sich der erste Lichtstrahl (10) senkrecht zum elektrischen Feld ausbreitet.

5. Verfahren nach Anspruch 4, bei dem der aus dem Pockelskristall (2) austretende zweite Lichtstrahl (12a,12b) außerhalb des Pockelskristalls (2) umgelenkt, erneut in den Pockelskristall (2) eingekoppelt wird und diesen in entgegengesetzter Richtung durchquert.

6. Verfahren nach Anspruch 4 oder 5, bei dem in den Pockelskristall (2) zwei zweite Lichtstrahlen (12a, 12b) eingekoppelt werden, die unter 45° zu den senkrecht zur Strahlachse orientierten Polarisationseigenachsen des Pockelskristalls (2) linear polarisiert sind, wobei die beiden zweiten Lichtstrahlen (12a,12b) auf ihrem Lichtweg außerhalb des Pockelskristalls (2) relativ zueinander um ein ungeradzahliges Vielfaches von λ/4 phasenverschoben werden.

7. Einrichtung zur Messung einer elektrischen Spannung (U) unter Ausnutzung des longitudinalen und des transversalen Pockelseffektes, mit einem Pockelskristall (2) und mit einer Lichtquellenanordnung (8) zum Erzeugen und Einkoppeln wenigstens eines ersten und wenigstens eines zweiten linearpolarisierten Lichtstrahls (10 bis 12a,12b) in den Pockelskristall (2) derart, daß sich diese im Pockelskristall (2) senkrecht zueinander ausbreiten, sowie mit einer dem Pockelskristall (2) nachgeschalteten Empfangseinrichtung (24) zum Messen einer von der Spannung (U) abhängigen ersten Intensität ($I_1$) des ersten Lichtstrahls (10) hinter einem ersten Analysator (26), wobei die Länge des Lichtwegs des ersten Lichtstrahls (10) im Pockelskristall (2) derart bemessen ist, daß innerhalb eines vorbestimmten Meßbereiches ($U_M$) eine eineindeutige Beziehung zwischen der ersten Intensität ($I_1$) und der Spannung (U) besteht, und zum Messen einer von der Spannung (U) abhängigen zweiten Intensität ($I_{2a}$, $I_{2b}$) hinter einem zweiten Analysator (22a, b), wobei die Länge des Lichtwegs des zweiten Lichtstrahls (12a,12b) im Pockelskristall (2) derart bemessen ist, daß innerhalb des vorbestimmten Meßbereiches ($U_M$) eine periodische Beziehung zwischen der zweiten Intensität ($I_{2a},I_{2b}$) und der Spannung (U) besteht, und mit einer Auswerteeinrichtung (28) zum Auswählen eines eindeutigen Meßwertes für die Spannung (U) aus der zweiten Intensität $I_2$.

8. Einrichtung nach Anspruch 7, bei dem die Ausbreitungsrichtung des ersten Lichtstrahls (10) senkrecht zum elektrischen Feld orientiert ist.

9. Einrichtung nach Anspruch 8, mit einer außerhalb des Pockelskristalls (2) angeordneten Umlenkeinrichtung (20) zum Umlenken und Einkoppeln des aus dem Pockelskristall (2) austretenden zweiten Lichtstrahls (12a,12b) in den Pockelskristall (2) derart, daß er diesen in entgegengesetzter Richtung erneut durchquert.

10. Einrichtung nach Anspruch 8 oder 9, mit einer Lichterzeugungseinrichtung (6) zum Erzeugen und Einkoppeln von zwei parallelen zweiten Lichtstrahlen (12a,12b), die unter 45° zu den senkrecht zur Strahlachse orientierten Polarisationseigenachsen des Pockelskristalls (2) linear polarisiert und relativ zueinander um ein ungeradzahliges Vielfaches von λ/4 phasenverschoben sind.

**Claims**

1. Process for measuring an electrical voltage (U) using the longitudinal and the transverse Pockels effect, in which at least one first and at least one second linearly polarised light beam (10 or 12a, b, respectively) which propagate perpendicularly to each other in the Pockels crystal (2), is injected into the Pockels crystal (2), wherein the length of the optical path of the first light beam (10) in the Pockels crystal (2) is designed in such a way that, within a predetermined measuring range ($U_M$), an unambiguous relationship exists between a first intensity ($I_1$) measured downstream of a first analyser (26), and the voltage (U), and this first intensity is used to select one unambiguous measured value for the voltage (U) from the second intensity ($I_{2a}$, $I_{2b}$) measured downstream of second analyser (22a, b) and which, within the measuring range ($U_M$) is periodically dependent upon the voltage (U) .

2. Process according to Claim 1, in which a whole number n, which specifies to which period the second intensity ($I_{2a}$, $I_{2b}$) belongs, is derived from the first intensity ($I_1$).

3. Process according to Claim 2, in which the whole number n is calculated from the relationship n = int ($U_m/U_0$) from a first measured value ($U_m$) of the voltage (U) determined from the first intensity ($I_1$), wherein $U_0$ is the period of the second intensity ($I_{2a}$, $I_{2b}$), and in which a second measured value $U_{m1}<U_0$ belonging to the first period is assigned to the second intensity ($I_{2a}$, $I_{2b}$) and the voltage (U) is determined by the relationship $U_{m1} + (n - 1)U_0$.

4. Process according to Claim 1, 2 or 3, in which the first light beam (10) is propagated perpendicularly to the electric field.

5. Process according to Claim 4, in which the second light beam (12a, 12b) exiting the Pockels crystal (2) is deflected outside the Pockels crystal (2), is reinjected into the Pockels crystal (2) and traverses the latter in the opposite direction.

6. Process according to Claim 4 or 5, in which two second light beams (12a, 12b) are injected into the Pockels crystal (2), which are linearly polarised at 45° to the intrinsic polarisation axes of the Pockels crystal (2), that are orientated perpendicularly to the beam axis, wherein the two second light beams (12a, 12b) are phase-shifted relative to each other by an odd multiple of λ/4 on their optical path outside the Pockels crystal (2).

7. Device for measuring an electrical voltage (U) using the longitudinal and the transverse Pockels effect, with a Pockels crystal (2) and with a light source arrangement (8) for generating and injecting at least one first and at least one second linearly polarised light beam (10 to 12a, 12b) into the Pockels crystal (2), in such a way that these light beams are propagated perpendicularly to each other in the Pockels crystal (2), as well as with a receiving device (24) connected downstream of the Pockels crystal (2) for measuring a first intensity ($I_1$) of the first light beam (10), downstream of a first analyser (26), which first intensity is dependent on the voltage (U), wherein the length of the optical path of the first light beam (10) in the Pockels crystal (2) is designed so that, within a predetermined measuring range ($U_M$) an unambiguous relationship exists between the first intensity ($I_1$) and the voltage (U), and for measuring a second intensity ($I_{2a}$, $I_{2b}$), which is dependent on the voltage (U), downstream of a second analyser (22a, b), wherein the length of the optical path of the second light beam (12a, 12b) in the Pockels crystal (2) is designed so that, within the predetermined measuring range ($U_M$) a periodic relationship exists between the second intensity ($I_{2a}$, $I_{2b}$) and the voltage (U), and with an evaluation device (28) for selecting an unambiguous measured value for the voltage (U) from the second intensity $I_2$.

8. Device according to Claim 7, in which the direction of propagation of the first light beam (10) is orientated perpendicularly to the electric field.

9. Device according to Claim 8, with a deviating device (20) disposed outside the Pockels crystal (2) for deflecting and injecting the second light beam (12a, 12b) exiting the Pockels crystal (2) into the Pockels crystal (2) so that this second light beam traverses said Pockels crystal again in the opposite direction.

10. Device according to Claim 8 or 9, with a light generating device (6) for generating and injecting two parallel second light beams (12a, 12b) that are linearly polarised at 45° to the intrinsic polarisation axes of the Pockels crystal (2), orientated perpendicularly to the beam axis, and which light beams are phase-shifted relative to each other by an odd multiple of λ/4.

**Revendications**

1. Procédé pour mesurer une tension électrique (U) en exploitant l'effet de Pockel longitudinal et l'effet de Pockel transversal, dans lequel au moins un premier faisceau lumineux et au moins un second faisceau lumineux (10 ou 12a,b) sont injectés dans un cristal de Pockel (2) et se propagent dans le cristal de Pockel (2) perpendiculairement l'un à l'autre ; la longueur du trajet optique du premier faisceau lumineux (10) dans le cristal de Pockel (2) est déterminée de telle sorte qu'il existe dans une plage de mesure prédéterminée une relation univoque entre la première intensité ($I_1$) mesurée en aval d'un premier analyseur (26) et la tension (U), laquelle relation est utilisée pour choisir une valeur de mesure déterminée pour la tension (U) à partir de la seconde intensité ($I_{1a, 2b}$) qui est mesurée en aval d'un second analyseur (22a, b) et qui est une fonction périodique de la tension (U) dans la plage de mesure ($U_M$).

2. Procédé selon la revendication 1, dans lequel on déduit à partir de la première intensité ($I_1$) un nombre entier n qui indique à quelle période appartient la seconde intensité ($I_{2a, 2b}$).

3. Procédé selon la revendication 2, dans lequel on calcul à partir d'une première mesure ($U_m$) de la tension (U), déterminée à partir de la première intensité ($I_1$), le nombre entier n en utilisant la relation n = int ($U_m/U_0$), $U_0$ étant la période de la seconde intensité ($I_{2a}$, $I_{2b}$), et dans lequel une seconde valeur de mesure $U_{m1}<U_0$ appartenant à la première période est associée à la seconde intensité ($I_{2a}$, $I_{2b}$) et la tension (U) est déterminée par la relation $U_{m1}+(n-1)U_0$.

4. Procédé selon la revendication 1, 2 ou 3, dans lequel le premier faisceau lumineux (10) se propage perpendiculairement au champ électrique.

5. Procédé selon la revendication 4, dans lequel le second faisceau lumineux (12a, 12b) sortant du cristal de Pockel (2) est dévié à l'extérieur du cristal de Pockel (2), injectés de nouveau dans le cristal de Pockel (2) et traverse celui-ci en sens opposé.

6. Procédé selon la revendication 4 ou 5, dans lequel deux seconds faisceaux lumineux (12a, 12b) sont injectés dans le cristal de Pockel (2) et sont polarisés linéairement à 45° par rapport aux axes de polarisation propres du cristal de Pockel (2) qui sont orientés perpendiculairement à l'axe des faisceaux ; les deux seconds faisceaux lumineux (12a, 12b) étant déphasés l'un par rapport à l'autre d'un multiple impair de fois de $\lambda/4$ sur leur trajet optique à l'extérieur du cristal de Pockel (2).

7. Dispositif pour mesurer une tension électrique (U) en exploitant l'effet de Pockel longitudinal et l'effet de Pockel transversal, comportant un cristal de Pockel (2) et un agencement de sources lumineuses (8) pour générer et injecter au moins un premier faisceau lumineux et au moins un second faisceau lumineux (10 à 12a, 12b) polarisés linéairement dans le cristal de Pockel (2) de sorte que ceux-ci se propagent perpendiculairement l'un à l'autre dans le cristal de Pockel (2), ainsi qu'un récepteur (24) agencé en aval du cristal de Pockel (2) pour mesurer une première intensité ($I_1$) du premier faisceau lumineux (10) qui est fonction de la tension (U) en aval d'un premier analyseur (26) ; la longueur du trajet optique du premier faisceau lumineux (10) dans le cristal de Pockel étant déterminée de telle sorte qu'il existe à l'intérieur d'une plage de mesure prédéterminée ($U_M$) une relation univoque entre la première intensité ($I_1$) et la tension (U) et pour mesurer une seconde intensité ($I_{2a, 2b}$) dépendant de la tension (U) en aval d'un second analyseur (22a, b) ; la longueur du trajet optique étant déterminée de telle sorte qu'il existe à l'intérieur de la plage de mesure prédéterminée ($U_M$) une relation périodique entre la seconde intensité ($I_{2a, 2b}$) et la tension (U), et un dispositif d'exploitation (28) pour choisir une valeur de mesure univoque pour la tension (U) à partir de la seconde intensité $I_2$.

8. Dispositif selon la revendication 7, dans lequel la direction de propagation du premier faisceau lumineux (10) est orientée perpendiculairement au champ électrique.

9. Dispositif selon la revendication 8, comportant un dispositif de déviation (20) disposé à l'extérieur du cristal de Pockel (2) en vue de dévier et injecter dans le cristal le second faisceau lumineux (12a, 12b) sortant du cristal de Pockel (2) de façon à le traverser en sens opposé.

10. Dispositif selon la revendication 8 ou 9, comportant un générateur de lumière (6) pour générer et injecter deux faisceaux lumineux parallèles (12a, 12b) qui sont polarisés linéairement à 45° par rapport aux axes de polarisation propres du cristal de Pockel (2) orientés perpendiculairement à l'axe des faisceaux et qui sortent déphasés l'un par rapport à l'autre d'un multiple impair de $\lambda/4$.

FIG 1

**FIG 2a**

**FIG 2b**